# FASCICULE DE BREVET EUROPEEN

(11) **EP 3 799 301 B1**
(45) Date de publication et mention de la délivrance du brevet: **10.08.2022**
(21) Numéro de dépôt: 20197661.0
(22) Date de dépôt: 23.09.2020
(51) Int. Cl.: H03C 1/36, H03C 3/24, H03C 5/00, H04L 27/36, H03C 1/62

(54) **DISPOSITIF ET PROCÉDÉ DE MODULATION D'AMPLITUDE**
VORRICHTUNG UND VERFAHREN ZUR AMPLITUDENMODULATION
DEVICE AND METHOD FOR AMPLITUDE MODULATION

(30) Priorité: 24.09.2019 FR 1910517
(43) Date de publication de la demande: 31.03.2021
(73) Titulaire: Commissariat à l'énergie atomique et aux énergies alternatives, 75015 Paris (FR)
(72) Inventeur: GONZALEZ JIMENEZ, José-Luis, 38054 GRENOBLE CEDEX 09 (FR)
(74) Mandataire: Brevalex

(56) Documents cités:
- EP-A1- 3 079 320
- US-A1- 2016 112 054
- HAN YAN ET AL: "An Ultra-Low-Power BPSK Receiver and Demodulator Based on Injection-Locked Oscillators", IEEE TRANSACTIONS ON MICROWAVE THEORY AND TECHNIQUES, PLENUM, USA, vol. 59, no. 5, 1 mai 2011 (2011-05-01), pages 1339-1349, XP011477188, ISSN: 0018-9480, DOI: 10.1109/TMTT.2011.2116037

## Description

### DOMAINE TECHNIQUE

L'invention concerne le domaine de l'émission de signaux modulés en amplitude ou modulés en phase et en amplitude.

### ÉTAT DE LA TECHNIQUE ANTÉRIEURE

Il est connu d'utiliser des oscillateurs verrouillés par injection, ou ILO pour « Injection-Locked Oscillator », pour réaliser des modulations de phase simples telles que la modulation PSK ou « Phase-Shift Keying », et notamment QPSK ou « Quadrature Phase-Shift Keying ». Le document [1] propose notamment la réalisation de modulateurs QPSK basés sur des oscillateurs en quadrature, et le document [2] propose la réalisation de modulateurs QPSK basés sur des oscillateurs en anneau. Dans ces documents, la modulation est appliquée sur la porteuse générée par l'oscillateur. La modulation est obtenue en injectant des impulsions dans différents terminaux internes de l'oscillateur en fonction du déphasage nécessaire pour chaque symbole. L'avantage de ces oscillateurs est qu'il est possible de retrouver les quatre phases nécessaires pour la modulation QPSK. Dans le document [1], le signal obtenu en sortie est sous la forme d'impulsions afin de réduire la consommation électrique du dispositif, et le facteur de multiplication entre le signal de sortie RF et le signal d'horloge est de l'ordre de 41 dans le cas le plus élevé. Dans le document [2], le signal obtenu en sortie est modulé en continu et le facteur de multiplication entre le signal de sortie et le signal d'horloge est de 18.

Le document [3] décrit également la réalisation d'une modulation QPSK en utilisant des ILOs. Le déphasage est généré en utilisant le principe que la phase entre la sortie et l'entrée d'un ILO dépend de l'écart entre la fréquence d'entrée et la fréquence d'auto-oscillation de l'ILO. En changeant la fréquence d'auto-oscillation de l'ILO, la phase de la sortie est modifiée. Le signal en bande de base est utilisé de cette façon pour générer certaines des phases de la modulation QPSK, mais il faut aussi, pour certains des symboles, intervertir les sorties de l'ILO car la modification de la phase de sortie via le changement de la fréquence d'auto-oscillation de l'ILO ne peut couvrir qu'une plage de déphasage limitée. L'inversion des sorties de l'ILO est réalisée par un circuit auxiliaire. Ce document présente un transmetteur complet combinant l'ILO avec un amplificateur de puissance (PA ou « Power Amplifier ») commuté.

Le document [4] décrit un transmetteur un peu différent de celui décrit dans le document [3], qui ne comporte pas de circuit auxiliaire d'inversion de phase. Dans ce transmetteur, le signal en bande de base est utilisé pour changer la fréquence de l'ILO et accumuler un déphasage suffisant après chaque symbole pour générer une des quatre phases nécessaires pour la modulation QPSK du symbole suivant.

Le document [5] propose la génération d'une modulation QPSK basée sur un oscillateur verrouillé par injection diviseur de fréquence (ILFD ou « Injection-Locked Frequency Divider »). Dans ce document, le fait que l'ILFD divise aussi la phase est utilisé et permet de générer plus facilement un déphasage multiple de 90° en sortie avec des déphasages multiplies de 180° à l'entrée. Le circuit proposé utilise donc un circuit d'inversion de la polarité en entrée de l'ILO diviseur par deux pour implémenter la modulation QPSK à partir du signal en bande de base.

Dans les documents [1] à [5], différentes propriétés des ILOs sont utilisées et les modulations sont obtenues par des mécanismes de modification du signal d'injection qui agissent à l'intérieur du circuit ILO (pour les documents [1] et [2]), ou sur l'entrée (pour les documents [4] et [5]) ou à la fois sur l'entrée et la sortie (pour le document [3]). Par contre, les solutions proposées dans les documents [1] à [5] ne sont capables que de générer des modulations d'amplitude constante de type BPSK ou QPSK car elles agissent uniquement sur la phase de l'oscillation.

Le document [6] propose l'utilisation de deux leviers sur un ILO pour implémenter une modulation de phase et d'amplitude. La modulation implémentée comporte 16 symboles, construits avec 8 phases différentes comprises entre 0° et 215° par intervalles de 45° et deux niveaux d'amplitude. La génération de la phase se fait à travers n signaux de la même façon que dans le document [3], c'est-à-dire en agissant sur la fréquence d'auto-oscillation de l'ILO et sur un inverseur de phase à sa sortie. Le contrôle d'amplitude se fait en agissant sur des signaux obtenus sur des sources de polarisation de la partie résistance négative et des transistors d'injection de l'ILO. Cette technique nécessite donc agir aussi sur la structure interne de l'ILO pour générer la modulation.

Les techniques décrites dans les documents [1] à [6] ont des limitations. Celles qui sont basées sur une modification de la fréquence d'auto-oscillation de l'ILO souffrent de l'impact des variations liées au procédé de réalisation des composants de l'ILO et des variations de température, qui vont modifier la fréquence d'auto-oscillation et qui vont nécessiter une calibration pour garantir une génération correcte de la constellation de symboles (états de phase). En outre, les techniques qui se basent sur le déphasage du signal d'injection ou sur l'injection à différents endroits de l'ILO ne peuvent être utilisées que pour la génération de modulations de phase, mais pas de modulation d'amplitude. La seule technique qui permet d'implémenter une modulation de phase et d'amplitude utilise une technique de modification de la fréquence d'auto-oscillation de l'ILO pour la phase et le contrôle du courant de polarisation pour l'amplitude, avec un ensemble assez complexe de signaux de contrôle dérivés du flux binaire en bande de base appliqué à différents endroits de l'ILO.

Le document US 2016/112054 A1 divulgue un dispositif de génération d'un signal périodique stable en fréquence comportant deux générateurs de train d'oscillations répétées périodiquement (générateurs TORP).

### EXPOSÉ DE L'INVENTION

Un but de la présente invention est de proposer un dispositif de modulation d'amplitude ou de modulation de phase et d'amplitude réalisant une modulation directe de la porteuse par le signal en bande de base numérique et qui ne présente pas les inconvénients de l'art antérieur.

Pour cela, la présente invention propose un dispositif de modulation d'amplitude avec 2^{P} états d'amplitude différents et P nombre entier supérieur ou égal à 1, comprenant au moins :
- plusieurs générateurs de signaux TORP, chaque signal TORP correspondant à des trains d'oscillations répétés périodiquement à une fréquence F_{PRP} dont les oscillations sont de fréquence F_{OL} égale à N.F_{PRP}, avec N nombre entier supérieur ou égal à 2, et dont chaque train d'oscillations a une durée inférieure à 1/F_{PRP}, chacun des générateurs de signal TORP incluant au moins :
- un oscillateur apte à générer un signal périodique de fréquence F_{OL}, et
- un circuit d'alimentation configuré pour être commandé par un signal de commande d'alimentation périodique de fréquence F_{PRP} et relié à au moins une entrée d'alimentation électrique de l'oscillateur tel qu'il génère, lorsque le générateur de signal TORP est destiné à générer un train d'oscillations, une tension d'alimentation de l'oscillateur non nulle seulement pendant une partie d'une période 1/F_{PRP},
- un générateur d'un signal de code thermométrique codé sur au moins 2^{P} bits et codant un signal de modulation d'amplitude issu d'un signal d'information comprenant des symboles de données à coder,
- un circuit de commande des générateurs de signaux TORP, configuré pour appliquer ou non, sur une entrée de commande du circuit d'alimentation de chacun des générateurs de signaux TORP, un signal périodique de fréquence F_{PRP} en fonction de la valeur de chacun des bits du signal de code thermométrique, codant ainsi les symboles de données dans le signal de commande d'alimentation, et
- un circuit de traitement comprenant des entrées couplées à des sorties des générateurs de signaux TORP, et configuré pour réaliser une combinaison linéaire de signaux délivrés sur ses entrées.

Dans ce dispositif, chaque générateur de signal TORP réalise une synthèse de fréquence générant un signal à haute fréquence (F_{OL}) à partir d'un autre signal à plus basse fréquence (F_{PRP}), ces basse et haute fréquences étant proportionnelles et liées par un facteur multiplicateur élevé (par exemple quelques dizaines).

Pour la modulation d'amplitude, ce dispositif repose sur la commande de plusieurs générateurs de signaux TORP par un même signal, ces générateurs étant synchronisés avec le même signal et cohérents en phase entre eux par construction. La technique de modulation est beaucoup plus simple que dans les dispositifs de l'art antérieur car elle ne fait appel qu'à un seul signal d'entrée et ne nécessite pas de contrôle à l'intérieur des générateurs de signaux TORP.

L'oscillateur de chacun des générateurs de signaux TORP est tel que la fréquence F_{OL} est égale à N.F_{PRP}, avec N nombre entier supérieur ou égal à 2. F_{OL} correspond donc à une fréquence de l'une des harmoniques du spectre du signal de sortie du dispositif, et avantageusement l'harmonique centrale du spectre du signal de sortie du dispositif afin de maximiser l'amplitude du signal à la fréquence F_{OL}.

Dans une configuration particulière, le dispositif peut comporter 2^{P} générateurs de signaux TORP, le signal de code thermométrique étant dans ce cas codé sur 2^{P} bits tel que, quelle que soit la valeur du signal d'information, un des bits du signal de code thermométrique a une valeur différente de celle des autres bits du signal de code thermométrique.

Le dispositif de modulation peut être configuré pour réaliser une modulation de phase et d'amplitude et peut comporter en outre au moins un générateur d'un signal périodique de fréquence F_{PRP} modulé en phase, le circuit de commande des générateurs de signaux TORP étant configuré pour appliquer ou non, sur l'entrée de commande du circuit d'alimentation de chacun des générateurs de signaux TORP, le signal périodique de fréquence F_{PRP} modulé en phase en fonction de la valeur de chacun des bits du signal de code thermométrique. Une telle configuration permet de réaliser des modulations complexes qui ont pour avantage d'être plus résistantes aux imperfections radiofréquence, ou RF, telle que le bruit de phase.

Dans le cas d'une modulation de phase et d'amplitude, le signal à haute fréquence généré sert de porteuse, ou de signal porteur, et inclus, dès sa génération, l'information de modulation de phase. Du fait que la synthèse de fréquence générant la porteuse et que la modulation de cette porteuse sont réalisées directement à partir d'un signal numérique en bande de base, il n'est pas nécessaire d'utiliser des convertisseurs analogique-numérique et des mélangeurs IQ pour réaliser la conversion en fréquence du signal en bande de base vers la haute fréquence, ce qui permet de réduire la consommation du dispositif.

Le circuit de commande des générateurs de signaux TORP peut comporter plusieurs portes ET chacune configurée pour recevoir sur une première entrée un des bits du signal de code thermométrique et sur une deuxième entrée le signal périodique de fréquence F_{PRP}, les sorties des portes ET sur lesquelles sont délivrés les signaux de commande d'alimentation pouvant être couplées aux entrées de commande des circuits d'alimentation des générateurs de signaux TORP.

Lorsque le dispositif de modulation est configuré pour réaliser une modulation de phase et d'amplitude, le générateur du signal périodique de fréquence F_{PRP} modulé en phase peut être configuré pour appliquer, à un signal périodique de fréquence F_{PRP}, et pour chaque symbole à coder, un retard correspondant à un multiple de 1/(2^{X}.F_{OL}), permettant de réaliser une modulation de phase avec 2^{X} états de phase différents, X étant un nombre entier supérieur ou égal à 1.

Lorsque le dispositif de modulation est configuré pour réaliser une modulation de phase et d'amplitude, le générateur du signal périodique de fréquence F_{PRP} modulé en phase peut être configuré pour appliquer, sur une ou plusieurs périodes d'un signal périodique de fréquence F_{PRP}, un retard correspondant au symbole à coder. Le nombre de périodes du signal périodique de fréquence F_{PRP} dédiées à un symbole est choisi notamment en fonction du taux de modulation souhaité.

Lorsque le dispositif de modulation est configuré pour réaliser une modulation de de phase et d'amplitude avec 2^{X} états de phase différents, le générateur du signal périodique de fréquence F_{PRP} modulé en phase peut comporter au moins :
- une boucle à verrouillage de retards configurée pour recevoir en entrée un signal périodique de fréquence F_{PRP}, et
- un multiplexeur comprenant 2^{X} entrées couplées à différentes cellules de retard de la boucle à verrouillage de retards et sur lesquelles 2^{X} signaux périodiques de fréquence F_{PRP} retardés différemment les uns des autres sont obtenus, une entrée de commande sur laquelle un signal de modulation de phase déterminant l'état de phase à appliquer pour chaque symbole est destiné à être appliqué, et une sortie sur laquelle le signal périodique de fréquence F_{PRP} modulé en phase est destiné à être délivré, X étant un nombre entier supérieur ou égal à 1.

Lorsque F_{OL} = N.F_{PRP}, avec N nombre entier supérieur ou égal à 2, le dispositif de modulation peut être tel que :
- chaque cellule de retard applique un retard ΔT₁ = 1/(2^{X}.N.F_{PRP}), ou
- 2^{X} cellules de retard appliquent chacune un retard ΔT₁ = 1/(2^{X}.N.F_{PRP}), les autres cellules de retard de la boucle à verrouillage de retard appliquant un retard ΔT₂ > ΔT₁, ou
- chaque cellule de retard applique un retard ΔT₃ = 1/(4.N.F_{PRP}).

Le générateur du signal de code thermométrique peut être configuré pour recevoir en entrée un signal binaire de modulation d'amplitude codant sur P bits un de 2^{P} états d'amplitude différents, et pour convertir le signal binaire de modulation d'amplitude en signal de code thermométrique.

Le circuit de traitement peut correspondre à un additionneur.

Le circuit d'alimentation de chacun des générateurs de signaux TORP peut comporter au moins un interrupteur commandé.

L'invention concerne également un procédé de modulation d'amplitude avec 2^{P} états d'amplitude différents et P nombre entier supérieur à 1, mis en oeuvre avec un dispositif de modulation d'amplitude comprenant plusieurs générateurs de signaux TORP correspondant à des trains d'oscillations répétés périodiquement à une fréquence F_{PRP} dont les oscillations sont de fréquence F_{OL} égale à N.F_{PRP}, avec N nombre entier supérieur ou égal à 2, et dont chaque train d'oscillations a une durée inférieure à 1/F_{PRP}, chacun des générateurs incluant au moins :
- un oscillateur apte à générer un signal périodique de fréquence F_{OL}, et
- un circuit d'alimentation configuré pour être commandé par un signal de commande d'alimentation périodique de fréquence F_{PRP} et relié à au moins une entrée d'alimentation électrique de l'oscillateur tel qu'il génère, lorsque le générateur de signal TORP est destiné à générer un train d'oscillations, une tension d'alimentation de l'oscillateur non nulle seulement pendant une partie d'une période 1/F_{PRP},
dans lequel le procédé comprend au moins les étapes suivantes :
- génération d'un signal de code thermométrique codé sur au moins 2^{P} bits et codant un signal de modulation d'amplitude issu d'un signal d'information comprenant des symboles de données à coder,
- application ou non, en fonction de la valeur de chacun des bits du signal de code thermométrique, d'un signal périodique de fréquence F_{PRP} sur une entrée de commande du circuit d'alimentation de chacun des générateurs de signaux TORP, codant ainsi les symboles de données dans le signal de commande d'alimentation, et
- combinaison linéaire des signaux délivrés par les générateurs de signaux TORP.

Le procédé peut réaliser une modulation de phase et d'amplitude, et peut comporter en outre une génération d'un signal périodique de fréquence F_{PRP} modulé en phase, l'étape d'application du signal périodique de fréquence F_{PRP} pouvant être mise en oeuvre avec le signal périodique de fréquence F_{PRP} modulé en phase.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2A-2D représentent des exemples de diagrammes IQ de modulations de phase et d'amplitude ;
- la figure 3 représente un dispositif de modulation de phase et/ou d'amplitude selon un mode de réalisation particulier;
- la figure 4 représente des exemples de signaux utilisé et obtenu dans un générateur de signal TORP ;
- la figure 5 représente des exemples de signaux déphasés obtenus en sortie de plusieurs générateurs de signaux TORP ;
- la figure 6 représente trois spectres de trois signaux TORP modulés en phase différemment ;
- les figures 7A et 7B représentent des diagrammes IQ d'une modulation QPSK réalisée avec le dispositif de modulation de phase et/ou d'amplitude selon l'invention, avec différents paramètres de modulation de phase ;
- la figure 8 représente un premier exemple de réalisation d'un générateur de signal périodique modulé en phase ;
- la figure 9 représente un exemple d'addition cohérente de signaux TORP;
- les figures 10 et 11 représentent des exemples de signaux obtenus lors de la mise en oeuvre de modulation de phase et d'amplitude par un dispositif de modulation selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

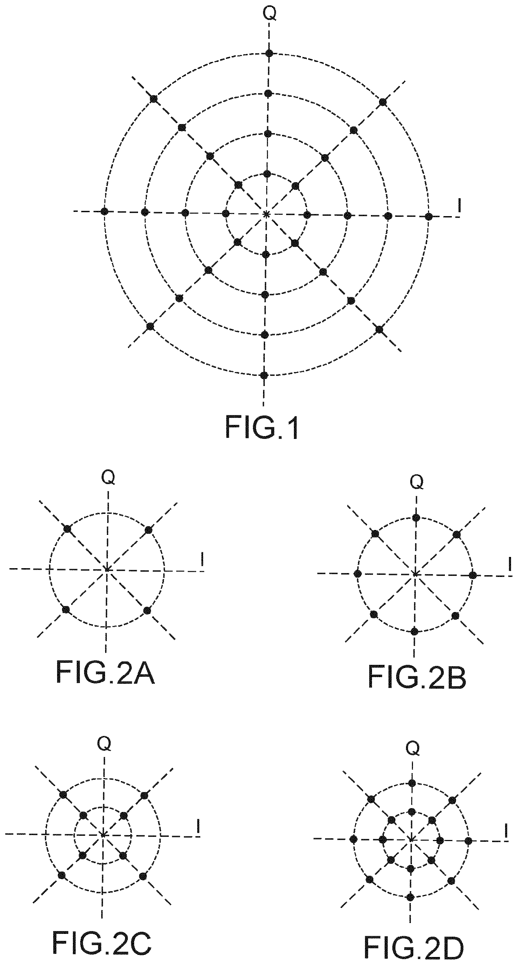

Les modulations de phase et d'amplitude, également appelées modulations polaires ou complexes, sont composées d'un certain nombre d'états de phase et d'états d'amplitude dans lesquels se trouve le signal modulé et qui peuvent être représentés par des points répartis dans un diagramme IQ, ou diagramme polaire ou diagramme de constellation, chacun de ces points représentant un état de modulation dans lequel la porteuse peut être modulée. Une modulation polaire 2^{X}x2^{P} comporte 2^{X} états de phase possibles et 2^{P} états d'amplitude possibles. Une telle modulation polaire 2^{X}x2^{P} a une efficacité spectrale de X + P bits par Hz et comporte un total de 2^{X+P} symboles. La figure 1 représente, dans un diagramme IQ, les 32 symboles possibles d'une modulation polaire 2³×2² (X=3, P=2). Chaque point visible sur ce diagramme correspond à un état de modulation possible, c'est-à-dire un des 32 symboles possibles.

Les figures 2A à 2D représentent respectivement les diagrammes IQ de modulation polaires particulières, à savoir la modulation QPSK (X=2, P=0) visible sur la figure 2A, la modulation 8PSK (X=3, P=0) visible sur la figure 2B, la modulation polaire 2²×2¹ visible sur la figure 2C, et la modulation polaire 2³×2¹ visible sur la figure 2D.

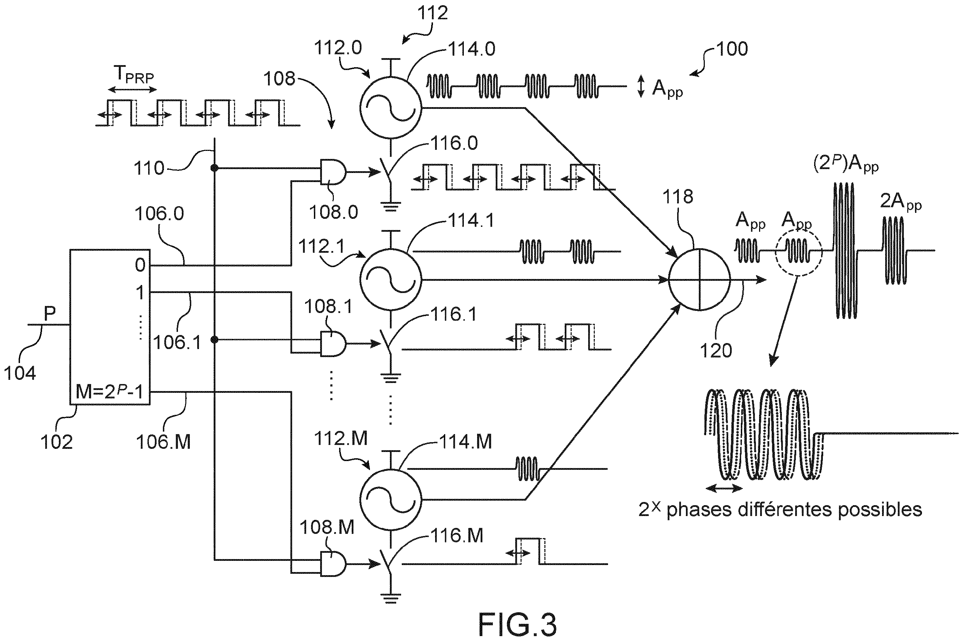

La figure 3 représente schématiquement un dispositif 100 de modulation de phase et d'amplitude selon un mode de réalisation particulier. Dans ce mode de réalisation particulier, le dispositif 100 est configuré pour réaliser une modulation de phase et d'amplitude de type 2^{X}×2^{P}.

Le dispositif 100 comporte un générateur 102 de signal de code thermométrique codé sur 2^{P} bits et codant un signal de modulation d'amplitude. Dans le mode de réalisation particulier décrit ici, le générateur 102 comporte une entrée 104 sur laquelle un signal de modulation d'amplitude codé sur P bits est reçu. Le signal de modulation d'amplitude transporte l'information relative à la modulation d'amplitude à appliquer sur le signal à moduler et code sur P bits un des 2^{P} états d'amplitude possibles pour chaque symbole de donnée à coder dans le signal à moduler. Le générateur 102 est configuré pour convertir le signal binaire de modulation d'amplitude en un signal de code thermométrique codé sur 2^{P} bits. Le générateur 102 comporte 2^{P} sorties 106, référencées 106.0 à 106.M (avec M = 2^{P} - 1) sur la figure 3, sur lesquelles les 2^{P} bits du signal de code thermométrique sont délivrés. Par exemple, pour un signal binaire de modulation d'amplitude codé sur 3 bits, le code binaire 000 correspond au code thermométrique 00000001, le code 001 au code 00000011, le code 010 au code 00000111, et ainsi de suite jusqu'au code binaire 111 qui correspond au code thermométrique 11111111.

Le signal binaire de modulation d'amplitude code sur P bits chacun des états d'amplitude devant être appliqués au signal modulé. Après la conversion réalisée par le générateur 102, chacun de ces états d'amplitude est codé sur les 2^{P} bits délivrés sur les sorties 106 du générateur 102.

Le dispositif 100 comporte également 2^{P} portes ET, référencées 108.0 à 108.M sur la figure 3. Chacune des portes ET 108.0 - 108.M comporte deux entrées, une première de ces deux entrées étant reliée à l'une des 2^{P} sorties 106.1 - 106.M du générateur 102 et une deuxième de ces deux entrées étant reliée à une ligne électrique 110 sur laquelle est délivré un signal périodique de fréquence F_{PRP}, correspondant par exemple à un signal carré.

Dans le mode de réalisation particulier décrit ici, le dispositif 100 est destiné à réaliser une modulation de phase et d'amplitude. Le signal délivré sur la ligne électrique 110 inclus l'information de modulation de phase, et est donc modulé en phase, c'est-à-dire est retardé périodiquement tel que sa phase code l'un parmi 2^{X} états de phase possibles pour chaque symbole du signal modulé. Pour faciliter la compréhension de l'invention, un exemple de signal périodique de fréquence F_{PRP} modulé en phase est représenté symboliquement sur la figure 3 à côté de la ligne 110.

Le dispositif 100 comporte également plusieurs, ici 2^{P}, générateurs 112 de signal TORP correspondant à des trains d'oscillations répétés périodiquement à la fréquence F_{PRP} dont les oscillations sont de fréquence F_{OL} égale à N.F_{PRP}, avec N nombre entier supérieur ou égal à 2, et dont chaque train d'oscillations a une durée inférieure à 1/F_{PRP}, référencés 112.0 à 112.M sur la figure 3. Chacun des générateurs de signal TORP 112.0 - 112.M comporte un oscillateur 114, référencés 114.0 - 114.M sur la figure 3, apte à générer un signal périodique de fréquence F_{OL}. Selon un exemple de réalisation, chaque oscillateur 114.0 - 114.M est de type VCO et est contrôlé en tension par un signal de contrôle V_{ctrl} (non visible sur la figure 3). Chacun des générateurs de signal TORP 112.0 - 112.M comporte également un circuit d'alimentation 116.0 - 116.M configuré pour être commandé par un signal de commande d'alimentation périodique de fréquence F_{PRP} qui correspond au signal obtenu en sortie de l'une des portes ET 108.0 - 108.M. Les circuits d'alimentation 116.0 - 116.M alimentent électriquement les oscillateurs 114.0 - 114.M et sont chacun reliés à une entrée d'alimentation électrique de chacun des oscillateurs 114.0 - 114.M. Les circuits d'alimentation 116.0 - 116.M génèrent des tensions d'alimentation des oscillateurs 114.0 - 114.M non nulle seulement pendant une partie de chaque période T_{PRP} = 1/F_{PRP}. Sur l'exemple de la figure 3, chacun des circuits d'alimentation 116.0 - 116.M comporte un interrupteur interposé entre une entrée d'alimentation électrique de l'un des oscillateurs 114.0 - 114.M et un potentiel électrique de référence.

Sur la figure 3, afin de faciliter la compréhension de l'invention, des exemples de signaux obtenus en sortie des portes ET 108 et des exemples de signaux délivrés par les générateurs 112 sont représentés.

Sur l'exemple de réalisation de la figure 3, les signaux de commande d'alimentation des générateurs de signaux TORP 112 qui sont appliqués sur les entrées de commande des circuits d'alimentation 116.0 - 116.M sont délivrés par les portes ET 108.0 - 108.M qui représentent un exemple de réalisation particulier. Plus généralement, le dispositif 100 comporte un circuit de commande 108 des 2^{P} générateurs de signaux TORP 112, configuré pour réaliser des fonctions logiques ET entre chacun des 2^{P} bits du signal de code thermométrique et le signal périodique de fréquence F_{PRP} appliqué en entrée du circuit de commande 108, et configuré pour appliquer, sur l'entrée de commande du circuit d'alimentation 116.0 - 116.M de chacun des 2^{P} générateurs de signal TORP 112, chacun des signaux de commande d'alimentation obtenus en sortie des fonctions logiques ET.

Les portes ET 108.0 - 108.M représentées sur la figure 3 correspondent à un exemple de réalisation particulier du circuit de commande 108. En variante, le circuit de commande 108, qui permet d'appliquer ou non sur l'entrée de commande du circuit d'alimentation 116.0 - 116.M de chacun des 2^{P} générateurs 112.0 - 112.M de signaux TORP le signal périodique de fréquence F_{PRP} en fonction de la valeur de chacun des 2^{P} bits du signal de code thermométrique, peut être réalisé avec d'autres structures logiques ou électroniques qui laissant passer ou non un signal entre une entrée et à une sortie en fonction d'une deuxième entrée de commande provenant du générateur 102.

Les sorties des oscillateurs 114.0 - 114.M, c'est-à-dire les sorties des 2^{P} générateurs de signal TORP 112.0 - 112.M, sont reliées aux entrées, ici au nombre de 2^{P}, d'un circuit de traitement 118 qui réalise une combinaison linéaire cohérente des signaux appliqués sur ses entrées et qui délivre sur sa sortie 120, formant la sortie du dispositif 100, un signal correspondant à la combinaison linéaire cohérente des signaux délivrés par les oscillateurs 114.0 - 114.M. Par exemple, comme représenté sur l'exemple de la figure 3, le circuit 118 peut correspondre à un additionneur. Il est également possible que le circuit de traitement 118 réalise une multiplication des signaux appliqués sur ses entrées par une variable, ce qui nécessite toutefois la présence d'un amplificateur variable.

Sur la figure 3, afin de faciliter la compréhension de l'invention, un exemple de signal modulé en phase et en amplitude, obtenu sur la sortie du dispositif 100, est représenté.

Dans le dispositif 100, la modulation de phase est générée par un déphasage du signal servant à commander la génération des signaux TORP par les générateurs 112.0 - 112.M, et la modulation d'amplitude est réalisée par la combinaison cohérente des signaux TORP délivrés en sortie des générateurs 112.0 - 112.M qui sont synchronisés par le même signal de commande qui est modulé en phase. La combinaison linéaire réalisée par le circuit de traitement 118 est cohérente car elle conserve la modulation de phase appliquée aux signaux TORP délivrés par les générateurs 112.0 - 112.M. Ainsi, lors de l'opération réalisée par le circuit de traitement 118, les signaux TORP à partir desquels la combinaison linéaire cohérente est réalisée sont en phase les uns avec les autres, et l'information de phase se retrouve dans le signal obtenu sur la sortie 120.

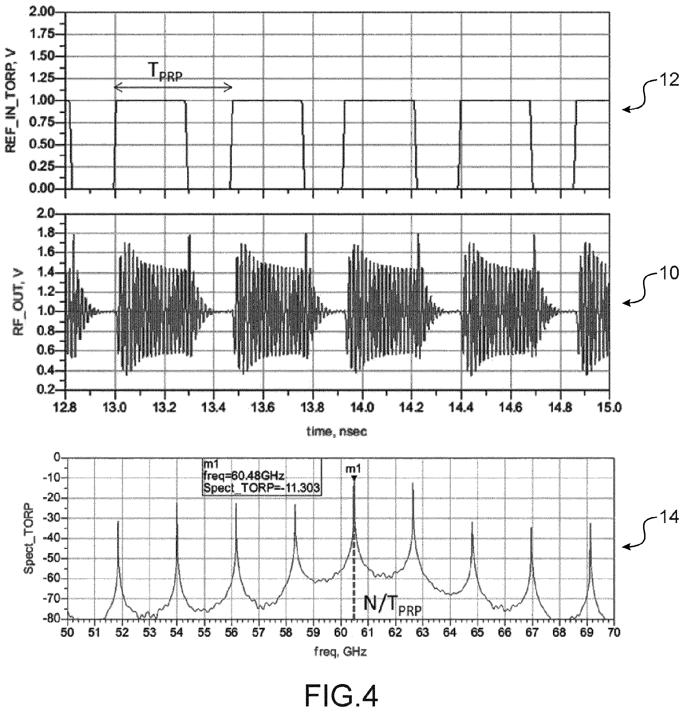

La figure 4 représente le signal TORP (qui porte la référence 10) obtenu en sortie d'un des générateurs 112.0 - 112.M lorsque ce générateur est commandé par un signal carré de période T_{PRP} (qui porte la référence 12) ne comportant pas d'information de modulation de phase. Le signal de sortie 10 obtenue correspond à un signal pulsé formé de trains d'oscillations à la fréquence d'oscillation libre de l'oscillateur 114, correspondant à F_{OL}, ces oscillations étant répétées périodiquement à la fréquence F_{PRP} du signal de commande appliqué en entrée du générateur de signal TORP. Chaque train d'oscillations a une durée inférieure à 1/F_{PRP}, ce qui signifie que le signal de commande a un rapport cyclique inférieur à 100 %.

Sur cette figure 4, le signal de commande d'alimentation 12 ne comporte pas de déphasage, contrairement à ce qui est réalisé dans le dispositif 100 lorsqu'une modulation de phase ou une modulation de phase et d'amplitude est mise en oeuvre. La référence 14 désigne le spectre du signal de sortie 10. Cette figure illustre la relation obtenue entre les périodes, et donc entre les fréquences, du signal de commande d'alimentation 12 et du signal de sortie 10 dans un tel générateur 112. Dans l'exemple de cette figure 4, la valeur de 1/T_{PRP}, c'est-à-dire la fréquence du signal de commande d'alimentation 12, est égale à 2,16 GHz, et le signal de commande d'alimentation 12 a un rapport cyclique (« duty cycle ») égal à 65 %. Quand le signal de commande d'alimentation 12 n'est pas modulé en phase, le spectre du signal de sortie 10 est composé d'un peigne de termes harmoniques se trouvant avantageusement à des fréquences multiples entières de la fréquence d'entrée 1/T_{PRP}, c'est-à-dire 1/T_{PRP}, 2/T_{PRP}, ..., (N-1)/T_{PRP}, N/T_{PRP}, (N+1)/T_{PRP}, etc. N correspond au facteur de multiplication entre la fréquence F_{PRP} du signal de commande d'alimentation 12 et le terme central du spectre du signal TORP 10. Le terme de fréquence égale à N/T_{PRP} correspond à celui ayant la plus grande amplitude et il se trouve autour de la fréquence d'auto-oscillation du générateur 112. Dans l'exemple de la figure 4, N = 28.

Le fonctionnement détaillé du générateur 112 est décrit dans le document EP 2 786 492 B1 ou dans le document EP 2 966 784 B1. Les différentes variantes de réalisation du générateur de signal TORP décrites dans le document EP 2 786 492 B1 ou dans le document EP 2 966 784 B1 peuvent s'appliquer pour la réalisation des générateurs 112 du dispositif 100 décrit ici.

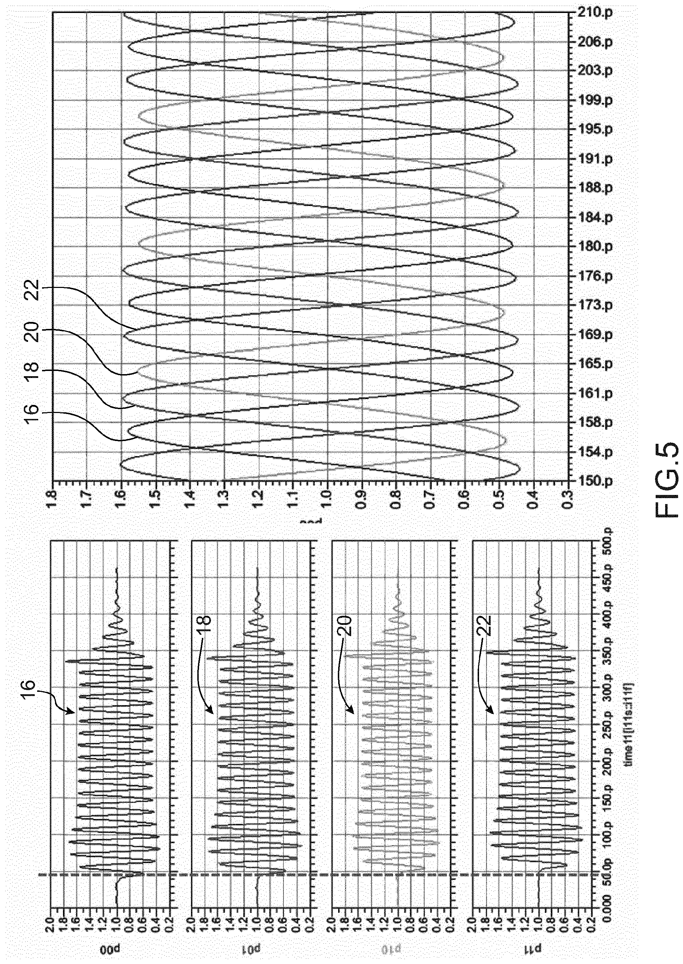

Pour appliquer la modulation de phase aux signaux de commande d'alimentation des générateurs 112.0 - 112.M, les signaux de commande d'alimentation sont retardés périodiquement d'une valeur correspondant à l'état de modulation de phase souhaité. Par exemple, lorsque le dispositif 100 réalise une modulation polaire 2²×2^{P} telle qu'une modulation QPSK, c'est à dire comportant quatre états de phase, le déphasage appliqué correspond à l'une des quatre valeurs suivantes : 0°, 90°, 180°, et 270°. Ces valeurs correspondent à des retards de 0, ¼, ½ et ¾ de la période de la porteuse, c'est-à-dire d'un signal sinusoïdal de fréquence F_{OL} ou N/T_{PRP} dans le mode de réalisation particulier décrit ici. Ces déphasages peuvent donc être générés par des décalages temporels du signal de commande d'une durée égale à 0, T_{PRP/}4N, 2T_{PRP}/4N, et 3T_{PRP}/4N. La figure 5 représente des exemples de signaux TORP retardés d'une durée égale à 0 (signal référencé 16), T_{PRP}/4N (signal référencé 18), 2T_{PRP}/4N (signal référencé 20), et 3T_{PRP}/4N (signal référencé 22).

La modulation de phase peut se faire sur chaque période des signaux de commande d'alimentation des générateurs 112.0 - 112.M ou à une fréquence inférieure à celle des signaux de commande. Autrement dit, un état de phase différent, correspondant à un symbole différent, peut être appliqué à chaque période des signaux de commande d'alimentation des générateurs 112.0 - 112.M, ou un même état de phase d'un seul symbole peut être appliqué sur plusieurs périodes, par exemple deux ou trois périodes, des signaux de commande d'alimentation des générateurs 112.0 - 112.M. Cette fréquence avec laquelle la modulation de phase est appliquée aux signaux de commande d'alimentation des générateurs 112.0 - 112.M peut s'exprimer en termes de nombre d'impulsions, ou nombre de trains d'oscillations, par symbole (ou état de phase), ce qui représente le nombre d'impulsions ou de trains d'oscillations de chaque signal de commande d'alimentation auquel chaque état de phase est appliqué. Toutes les impulsions, ou tous les trains d'oscillations, des signaux de commande d'alimentation des générateurs 112.0 - 112.M associées à un même symbole ont donc la même phase. Le taux de modulation du dispositif 100 correspond donc à une fraction de la fréquence du signal de commande d'alimentation des générateurs 112.0 - 112.M dont la valeur dépend du nombre de d'impulsions ou de trains d'oscillations par symbole, avec une limite supérieure correspondant à la valeur de la fréquence du signal de commande d'alimentation des générateurs 112.0 - 112.M (limite supérieure qui correspond au cas où un état de phase d'un symbole est appliquer à une seule impulsion ou un seul train d'oscillations des signaux de commande des générateurs 112.0 - 112.M).

Par exemple, si 1/T_{PRP} = 2,16 GHz et si une impulsion ou un train d'oscillations est utilisé pour chaque symbole, le taux de modulation obtenu est de 2,16 Gsymboles/s ou 2,16 Gbauds/s. Si l'état de phase de chaque symbole est appliqué à deux impulsions ou deux trains d'oscillation des signaux de commande des générateurs 112.0 - 112.M, le taux de modulation obtenu est alors de 1,08 Gsymboles/s ou 1,08 Gbauds/s.

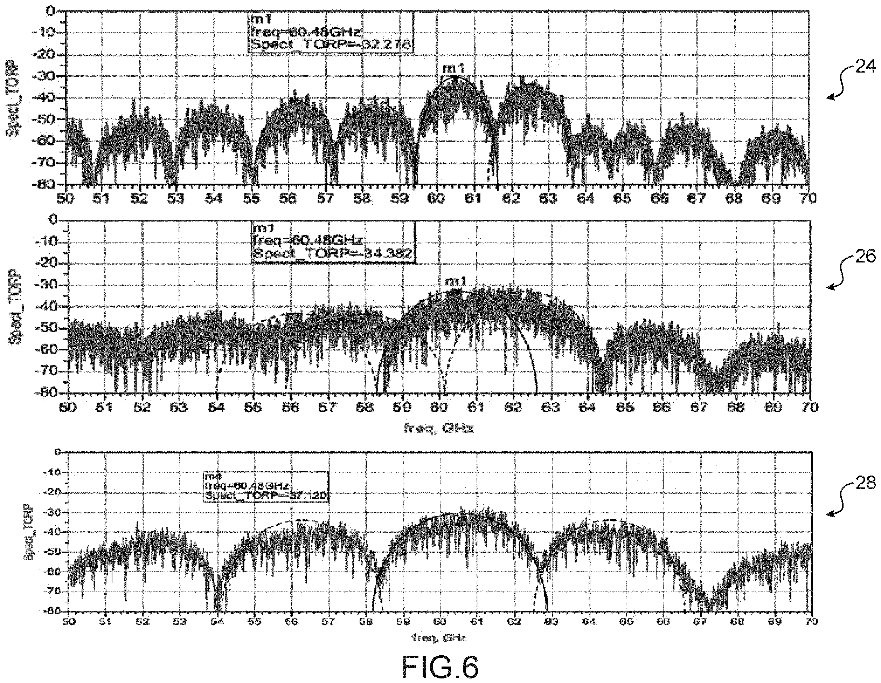

La figure 6 représente trois spectres de signaux TORP modulés en phase obtenus avec des paramètres de modulation phase différents. Le spectre référencé 24 correspond au cas où la fréquence de la modulation de phase est telle qu'une impulsion ou un train d'oscillations est utilisé pour chaque symbole, avec 1/T_{PRP} = 2,16 GHz et N/T_{PRP} = 60,48 GHz, avec 4 états de phase différents possibles. Sur le spectre 24, la modulation des harmoniques adjacents à l'harmonique centrale (à la fréquence N/T_{PRP}) s'étend dans la bande de fréquences de la modulation sur l'harmonique centrale. Le spectre référencé 26 correspond au cas où la fréquence de la modulation de phase est telle que deux impulsions ou deux trains d'oscillations sont utilisés pour chaque symbole, avec 1/T_{PRP} = 2,16 GHz et N/T_{PRP} = 60,48 GHz, et avec 4 états de phase différents possibles. Le spectre référencé 28 correspond au cas où la fréquence de la modulation de phase est telle que deux impulsions ou deux trains d'oscillations sont utilisés pour chaque symbole, avec 1/T_{PRP} = 4,32 GHz et Nx1/T_{PRP} = 60,48 GHz, et avec 4 états de phase différents possibles. Dans les spectres 26 et 28, la modulation des harmoniques adjacents à l'harmonique centrale ne s'étend pas dans la bande de fréquences de la modulation du l'harmonique centrale. Ainsi, pour éviter le recouvrement entre les bandes de fréquences des harmoniques, il est possible d'augmenter la fréquence du signal de commande et/ou le nombre d'impulsions, ou de trains d'oscillations, par symbole pour garder le même débit binaire et espacer les fréquences des harmoniques adjacents à l'harmonique centrale.

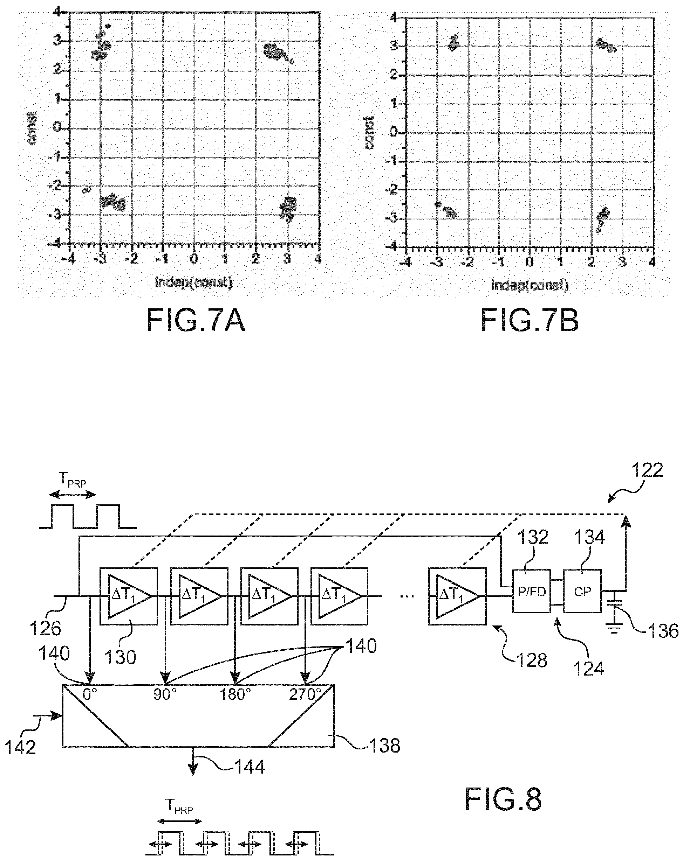

La figure 7A représente le diagramme IQ d'une modulation QPSK réalisée avec le dispositif 100, avec une impulsion ou un train d'oscillations utilisé pour chaque symbole, 1/T_{PRP} = 2,16 GHz et un débit de 2,16 Gbauds/s. La figure 7B représente le diagramme IQ d'une modulation QPSK réalisée avec le dispositif 100, avec deux impulsions ou deux trains d'oscillations utilisés pour chaque symbole, 1/T_{PRP} = 4,32 GHz et un débit de 2,16 Gbauds/s. Ces diagrammes montrent qu'une plus faible dispersion des états de modulation est obtenue en augmentant le nombre d'impulsions ou de trains d'oscillations utilisés pour chaque symbole et/ou la fréquence du signal de commande des générateurs 112.0 - 112.M du dispositif 100.

Le déphasage du signal de commande d'alimentation des générateurs 112.0 - 112.M peut être réalisé par un générateur 122 du signal périodique de fréquence F_{PRP} modulé en phase. La figure 8 représente un premier exemple de réalisation d'un tel générateur 122.

Dans ce premier exemple de réalisation, le générateur 122 comporte une boucle à verrouillage de retard 124. Cette boucle 124 comporte une entrée 126 sur laquelle un signal périodique, par exemple un signal carré, dont la fréquence détermine la valeur de F_{PRP}, est appliqué. La boucle 124 comporte une ligne de retard 128 dans laquelle le signal périodique de fréquence F_{PRP} est injecté. La ligne de retard 128 est formée de plusieurs cellules de retard 130 couplées en série les unes aux autres. Le retard appliqué par chaque cellule de retard 130 est par exemple égal à ΔT₁ = T_{PRP}/(N.2^{X}). Le nombre total K de cellules 130 est par exemple K = N.2^{X}. Cette structure est communément appelée DLL ou « Delay Locked Loop ». La boucle 124 comporte également un comparateur de phase et fréquence 132 (P/FD) dont l'entrée est couplée à la sortie de la dernière cellule de retard 130 de la ligne 128, une pompe de charge 134 (CP) dont l'entrée est couplée à la sortie du comparateur 132, et un filtre 136 couplé à la sortie de la pompe de charge 134 et représenté par une capacité sur l'exemple de la figure 8. La ligne 128 est contrôlée en tension via une tension de commande obtenue en sortie du filtre 136 et appliquée sur une entrée de commande de chacune des cellules de retard 130. La boucle 124 ajuste donc le retard des cellules 130, via la tension de commande obtenue en sortie du filtre 136, pour garantir un retard global égal à la période du signal périodique appliqué sur l'entrée 126 qui fixe ce temps à la valeur de T_{PRP}.

Selon une première variante de réalisation de la boucle 124, il est possible que toutes les cellules 130 n'appliquent pas le même retard. Par exemple, il est possible que les 2^{X} premières cellules 130 appliquent le retard ΔT₁ = T_{PRP}/(N.2^{X}), et que les autres cellules 130 (c'est-à-dire les K-2^{X} cellules restantes) appliquent un retard ΔT₂ > ΔT₁. Ainsi, pour un retard donné de la ligne 128, il est possible de réduire le nombre total de cellules de retard 130 permettant l'obtention de ce retard. Dans cette variante, la tension de commande obtenue en sortie du filtre 136 est traitée avant d'être appliquée sur l'entrée de commande de chacune des cellules de retard 130. Ce traitement de la tension obtenue en sortie du filtre 136 et issue de la boucle 124 varie pour chaque cellule 130 suivant la valeur du retard à appliquer par chaque cellule 130. Ce traitement peut être réalisé par des circuits conventionnels de traitement de signaux continus (amplificateurs, ponts résistifs, convertisseurs DC/DC) appliquant, pour chaque cellule 130, une loi agissant sur la valeur de la tension de commande à appliquer en entrée de la cellule 130 en fonction de la valeur du retard souhaitée. Ainsi, la consommation de la boucle 124 est réduite grâce à la réduction du nombre de cellules de retard 130 formant la ligne 128 qui permet de générer un retard total cumulé égal à une période du signal appliqué sur l'entrée 126, et grâce à la réduction du nombre de transitions s'opérant au sein de la boucle 124.

Selon une deuxième variante de réalisation de la boucle 124, si le produit (N.2^{X}) est un multiple de 4, il est possible de le décomposer en deux autres produits tels que P.2^{X}/4 = N.2^{X}. Il est donc possible de trouver 2^{X} phases différentes à partir de retards plus importants ΔT₃ = T_{PRP}/P. Ainsi, les cellules 130 peuvent appliquer chacune un retard ΔT₃, ce qui permet de réduire la consommation de la boucle 124 du fait que cette consommation est proportionnelle au nombre de transitions de signal s'opérant au sein de la boucle 124 sur une période de temps donnée.

Le générateur 122 comporte également un multiplexeur 138 comprenant au moins 2^{X} entrées 140 couplées à différentes sorties de la ligne 128 sur lesquelles 2^{X} signaux périodiques de fréquence FPRP retardés différemment les uns des autres, avec les différents retards correspondant à tous les états de phase souhaités, sont obtenus. Le signal obtenu sur chaque sortie de la ligne 128 correspond à une version retardée du signal d'entrée. Le multiplexeur 138 comporte une entrée de commande 142 sur laquelle un signal de commande de modulation de phase déterminant l'état de phase à appliquer pour chaque symbole est appliqué. Ce signal de commande correspond par exemple à un signal binaire, et permet de sélectionner le retard correspondant au déphasage de chaque symbole à appliquer au signal porteur à moduler. Le multiplexeur 138 comporte une sortie 144, formant la sortie du générateur 122, sur laquelle le signal périodique de fréquence F_{PRP} modulé en phase est obtenu.

Le nombre de sorties de la ligne 128 appliquées sur les entrées 140 du multiplexeur 138 est par exemple égal à la division d'une période du terme central (harmonique centrale) du spectre du signal de sortie d'un des générateurs 112.0 - 112.M (c'est-à-dire N/T_{PRP}) par le nombre d'états de phases de la modulation (c'est-à-dire 2^{X}).

Sur l'exemple de la figure 8, le générateur 122 est adapté pour réaliser une modulation de phase à 4 états de phase (X = 2).

Dans le dispositif 100, le routage entre la sortie du générateur 122 et les entrées de commande des circuits d'alimentation 116.0 - 116.M des générateurs 112 est équilibré dans chacune des branches afin que le signal périodique de fréquence F_{PRP} soit très bien synchronisé au niveau de chacune des entrées de commande des circuits d'alimentation 116.0 - 116.M des générateurs 112.

Dans le dispositif 100, la modulation d'amplitude est réalisée en utilisant la propriété de chaque générateur 112.0 - 112.M de garantir la cohérence de phase entre le signal appliqué sur l'entrée de commande du circuit d'alimentation 116.0 - 116.M de chaque générateur 112.0 - 112.M et le signal délivré en sortie de chaque générateur 112.0 - 112.M. Ainsi, deux générateurs de signaux TORP commandés par le même signal d'entrée vont générer deux signaux de sortie cohérents en phase entre eux et qui peuvent donc être combinés, par exemple additionnés, sans perdre l'information de phase. Ce mécanisme de combinaison cohérente permet générer un signal avec plusieurs valeurs discrètes possibles d'amplitude allant de 1 à 2^{P} en fonction du signal de modulation d'amplitude.

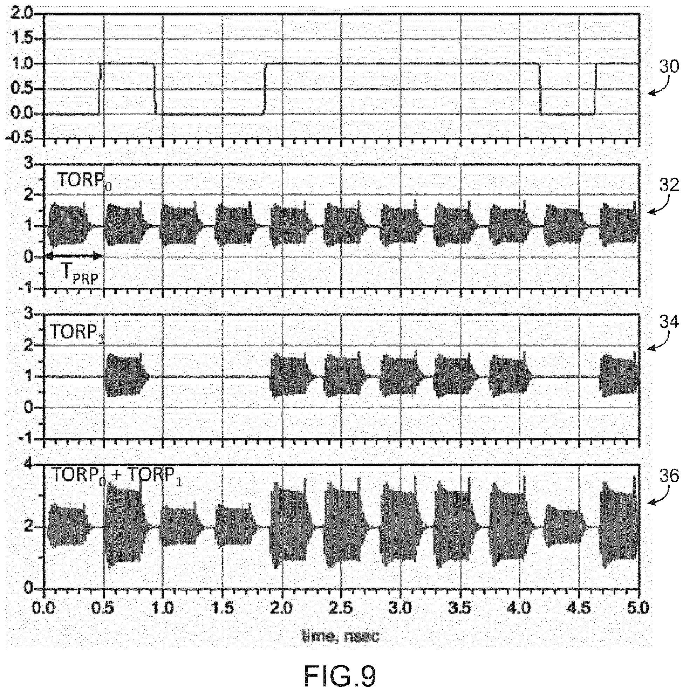

La figure 9 montre des exemples de signaux obtenus avec le dispositif 100 lorsque P=1, ce qui permet de coder 1 bit d'information sur l'amplitude du signal obtenu par la combinaison linéaire, par exemple l'addition, cohérente des deux signaux TORP obtenus par des générateurs 112 synchronisés avec le même signal d'entrée, avec un des deux générateurs fonctionnant conditionnellement en fonction de la valeur du signal de modulation d'amplitude. La référence 30 désigne le signal de modulation d'amplitude, la référence 32 désigne le premier signal TORP, la référence 34 désigne le deuxième signal TORP, et la référence 36 désigne le signal correspondant à la combinaison cohérente, ici l'addition cohérente, des deux signaux 32 et 34.

Dans le dispositif 100, chaque bit du code thermométrique est utilisé, via le circuit de commande 108, pour laisser passer ou non le signal périodique appliqué en entrée du générateur 112 associé à chaque bit thermométrique. Sur une période T_{PRP}, la valeur de l'amplitude du signal de sortie délivré par le circuit 118 va correspondre au nombre de bits du code thermométrique permettant l'application du signal délivré sur la ligne 110 (par exemple les bits de valeurs '1') sur les entrées de commande des circuits d'alimentation 116.0 - 116.M des générateurs 112 multiplié par l'amplitude d'un signal délivré par l'un des générateurs 112.

Dans le dispositif 100, les deux techniques de modulation de la phase et l'amplitude peuvent être appliquées de façon indépendante sur les signaux d'entrée d'un ensemble de générateurs 112. La modulation de phase est appliquée sur les signaux de commande de tous les générateurs 112, et la modulation d'amplitude est appliquée via le code thermométrique qui contrôle le nombre de signaux TORP que sont combinés ensemble. Cette technique permet appliquer en même temps les deux types de modulation sur le signal final, ce qui résulte en une technique générique de réalisation de modulation polaire.

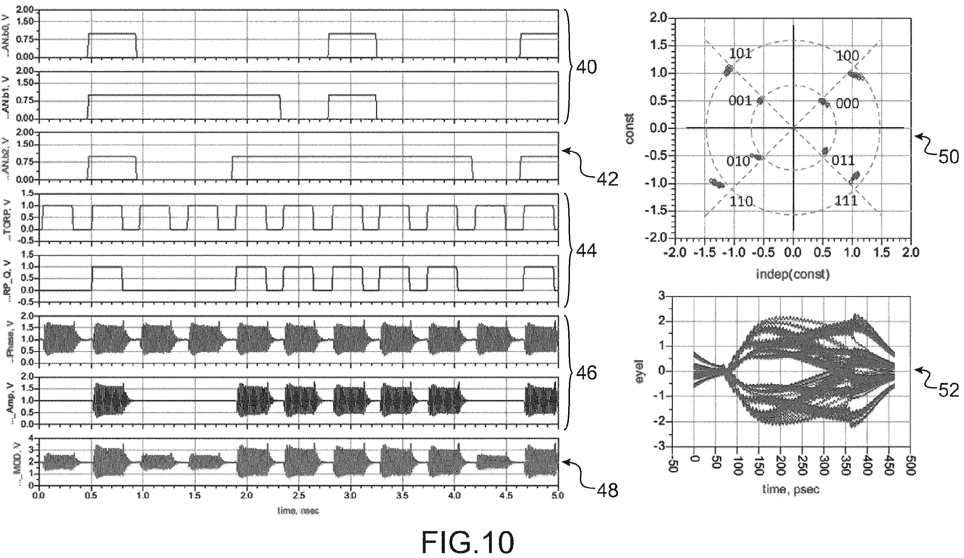

Un exemple de résultats pour une modulation de phase et d'amplitude de trois bits, avec deux bits dédiés à la modulation de phase, et le troisième bit pour la modulation d'amplitude, est illustré sur la figure 10. Une telle modulation est obtenue en utilisant deux générateurs 112 de signaux TORP. Sur cette figure 10, la référence 40 désigne le signal de modulation de phase codé sur deux bits, la référence 42 désigne le signal de modulation d'amplitude codé sur 1 bit, la référence 44 désigne les signaux de commande des circuits d'alimentation 116.0 - 116.M des générateurs 112, la référence 46 désigne les signaux TORP obtenus en sortie de chacun des générateurs 112, et la référence 48 désigne le signal de sortie du dispositif 100 correspondant à un signal TORP modulé en phase et en amplitude. La référence 50 désigne le diagramme IQ obtenu avec cette modulation. La référence 52 désigne le diagramme de l'œil obtenu avec cette modulation.

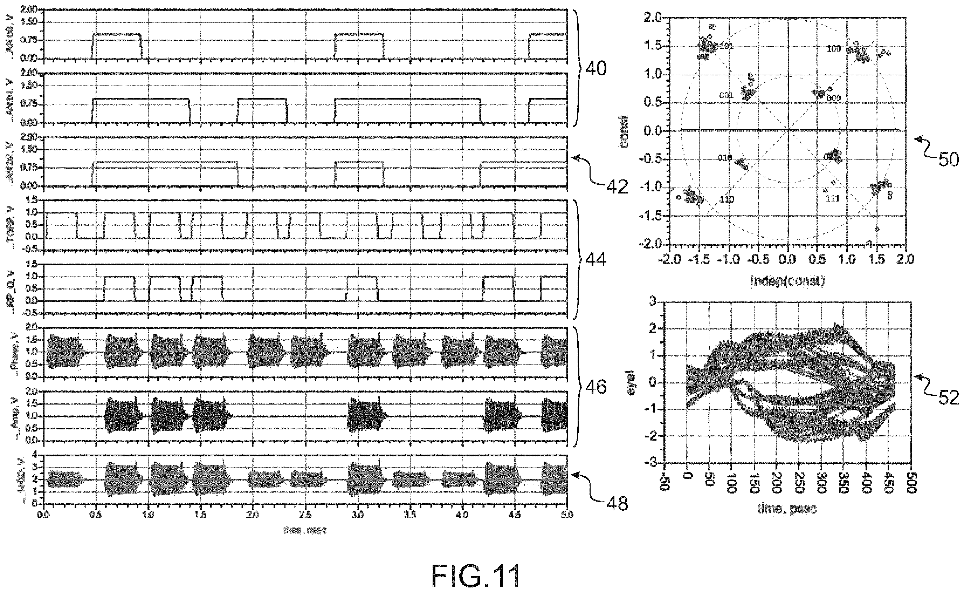

Un autre exemple de résultats pour une modulation de phase et d'amplitude de trois bits, avec deux bits dédiés à la modulation de phase, et le troisième bit pour la modulation d'amplitude, est illustré sur la figure 11. Ces résultats sont obtenus avec un dispositif 100 similaire à celui utilisés pour obtenir les résultats de la figure 10, mais dans lequel les retards des cellules 130 sont égaux à ΔT₃, et non ΔT₁ comme pour les résultats de la figure 10.

Dans le dispositif 100 précédemment décrit, la modulation réalisée correspond à une modulation de phase et d'amplitude.

Selon une variante, il est possible que seule une modulation d'amplitude soit réalisée par le dispositif 100. Dans ce cas, le dispositif 100 ne comporte pas de générateur 122 du signal périodique de fréquence F_{PRP} modulé en phase, et les générateurs 112 de signaux TORP sont alors commandés par un signal de commande de fréquence F_{PRP} ne comportant pas d'information modulée en phase.

Dans le mode de réalisation particulier du dispositif 100 précédemment décrit, le dispositif 100 comporte 2^{P} générateurs 112. En variante, il est possible que le dispositif 100 comporte un nombre de générateurs 112 supérieur à 2^{P}. Dans ce cas, il est possible qu'une partie seulement des générateurs 122 fonctionnent simultanément, les générateurs 112 en fonctionnement pouvant changer périodiquement.

De manière alternative, il est possible que le dispositif 100 comporte 2^{P}-1 générateurs 112, avec dans ce cas un générateur 102 générant un signal de code thermométrique codé sur 2^{P}-1 bits. Dans cette configuration, le code thermométrique composé de 0 uniquement (par exemple 0000000 pour un signal binaire de modulation d'amplitude codé sur 3 bits) est considéré comme correspondant à une des valeurs du code binaire, et se traduit par un signal d'amplitude nulle sur la sortie du dispositif 100. Un tel code thermométrique peut également être utilisé dans un dispositif 100 comportant plus de 2^{P}-1 générateurs 112.

Il est également possible que le dispositif 100 comporte seulement deux générateurs 112. Dans ce cas, le dispositif 100 peut réaliser une modulation d'amplitude avec au moins 2 états d'amplitude différents : l'un où un seul des générateurs 112 émet un signal TORP, et l'autre où les deux générateurs 112 émettent des signaux TORP.

En outre, il est également possible que dans le dispositif 100, pour une valeur du signal de modulation d'amplitude, le signal thermométrique ne soit pas toujours identique, et cela dans le but que ce ne soit pas toujours les mêmes générateurs 112 qui émettent le plus de signaux. Par exemple, en considérant le dispositif 100 représenté sur la figure 3 dans lequel le générateur 112.0 émet continuellement un signal TORP, il est possible qu'après une certaine durée de fonctionnement, cet envoi continu d'un signal TORP soit assuré non pas par le générateur 112.0 mais par un autre des générateurs 112.1-112.M. Il est possible d'assurer une certaine rotation de fonctionnement des générateurs 112 en décalant les valeurs des sorties 106 du générateur 102.

### Bibliographie

[1] A. M. El-Gabaly and C. E. Saavedra, "A 3-10 GHz 13 pJ/pulse dual BPSK/QPSK pulse modulator based on harmonic injection locking," 2014 IEEE MTT-S International Microwave Symposium (IMS2014), Tampa, FL, 2014, pp. 1-4.
[2] S. Y. Lee, H. Ito, N. Ishihara and K. Masu, "A Novel Direct Injection-Locked QPSK Modulator Based on Ring VCO in 180 nm CMOS," in IEEE Microwave and Wireless Components Letters, vol. 24, no. 4, pp. 269-271, April 2014.
[3] Y. Lei, X. Xing, H. Feng and Z. Wang, "A 20Mbps 5.8mw QPSK transmitter based on injection locking and Class-E PA for wireless biomedical applications," IEEE 12th International Conference on ASIC (ASICON), Guiyang, 2017, pp. 448-451.
[4] Z. Saheb, E. El-Masry and J. Bousquet, "A 69-Mbps dual tuning 8PSK/QPSK transmitter using injection locking and RF phase modulation," 2017 IEEE International Symposium on Circuits and Systems (ISCAS), Baltimore, MD, 2017, pp. 1-4.
[5] Z. Ji, S. Zargham and A. Liscidini, "Low-Power QPSK Transmitter Based on an Injection-Locked Power Amplifier," ESSCIRC 2018 - IEEE 44th European Solid State Circuits Conference (ESSCIRC), Dresden, 2018, pp. 134-137.
[6] CN 103199796 B

EP 2 786 492 B1
EP 2 966 784 B1

## Revendications

1. Dispositif (100) de modulation d'amplitude avec 2^{P} états d'amplitude différents et P nombre entier supérieur ou égal à 1, comprenant au moins :
- plusieurs générateurs (112.0-112.M) de signaux TORP, chaque signal TORP correspondant à des trains d'oscillations répétés périodiquement à une fréquence F_{PRP} dont les oscillations sont de fréquence F_{OL} égale à N.F_{PRP}, avec N nombre entier supérieur ou égal à 2, et dont chaque train d'oscillations a une durée inférieure à 1/F_{PRP}, chacun des générateurs (112.0-112.M) de signal TORP incluant au moins :
- un oscillateur (114.0-114.M) apte à générer un signal périodique de fréquence F_{OL}, et
- un circuit d'alimentation (116.0-116.M) configuré pour être commandé par un signal de commande d'alimentation périodique de fréquence F_{PRP} et relié à au moins une entrée d'alimentation électrique de l'oscillateur (114.0-114.M) tel qu'il génère, lorsque le générateur (112.0-112.M) de signal TORP est destiné à générer un train d'oscillations, une tension d'alimentation de l'oscillateur (114.0-114.M) non nulle seulement pendant une partie d'une période 1/F_{PRP},
- un générateur (102) d'un signal de code thermométrique codé sur au moins 2^{P} bits et codant un signal de modulation d'amplitude issu d'un signal d'information comprenant des symboles de données à coder,
- un circuit de commande (108) des générateurs (112.0-112.M) de signaux TORP, configuré pour appliquer ou non, sur une entrée de commande du circuit d'alimentation (116.0 - 116.M) de chacun des générateurs (112.0 - 112.M) de signaux TORP, un signal périodique de fréquence F_{PRP} en fonction de la valeur de chacun des bits du signal de code thermométrique, codant ainsi les symboles de données dans le signal de commande d'alimentation, et
- un circuit de traitement (118) comprenant des entrées couplées à des sorties des générateurs (112.0 - 112.M) de signaux TORP, et configuré pour réaliser une combinaison linéaire de signaux délivrés sur ses entrées.

2. Dispositif (100) selon la revendication 1, comprenant 2^{P} générateurs (112.0-112.M) de signaux TORP, et dans lequel le signal de code thermométrique est codé sur 2^{P} bits tel que, quelle que soit la valeur du signal d'information, un des bits du signal de code thermométrique a une valeur différente de celle des autres bits du signal de code thermométrique.

3. Dispositif (100) selon l'une des revendications précédentes, dans lequel le dispositif (100) est configuré pour réaliser une modulation de phase et d'amplitude et comporte en outre au moins un générateur (122) d'un signal périodique de fréquence F_{PRP} modulé en phase, et dans lequel le circuit de commande (108) des générateurs (112.0 - 112.M) de signaux TORP est configuré pour appliquer ou non, sur l'entrée de commande du circuit d'alimentation (116.0 - 116.M) de chacun des générateurs (112.0 - 112.M) de signaux TORP, le signal périodique de fréquence F_{PRP} modulé en phase en fonction de la valeur de chacun des bits du signal de code thermométrique.

4. Dispositif (100) selon la revendication 3, dans lequel le dispositif (100) est configuré pour réaliser une modulation de phase et d'amplitude avec 2^{X} états de phase différents, et dans lequel le générateur (122) du signal périodique de fréquence F_{PRP} modulé en phase est configuré pour appliquer, au signal périodique de fréquence F_{PRP}, et pour chaque symbole à coder, un retard correspondant à un multiple de 1/(2^{x}.F_{OL}), X étant un nombre entier supérieur ou égal à 1.

5. Dispositif (100) selon la revendication 4, dans lequel le générateur (122) du signal périodique de fréquence F_{PRP} modulé en phase comporte au moins :
- une boucle à verrouillage de retards (124) configurée pour recevoir en entrée le signal périodique de fréquence F_{PRP}, et
- un multiplexeur (138) comprenant 2^{X} entrées (140) couplées à différentes cellules de retard (130) de la boucle à verrouillage de retards (124) et sur lesquelles 2^{X} signaux périodiques de fréquence F_{PRP} retardés différemment les uns des autres sont obtenus, une entrée de commande (142) sur laquelle un signal de modulation de phase déterminant l'état de phase à appliquer pour chaque symbole est destiné à être appliqué, et une sortie (144) sur laquelle le signal périodique de fréquence F_{PRP} modulé en phase est destiné à être délivré.

6. Dispositif (100) selon la revendication 5, dans lequel :
- chaque cellule de retard (130) applique un retard ΔT₁ = 1/(2^{x}.N.F_{PRP}), ou
- 2^{X} cellules de retard (130) appliquent chacune un retard ΔT₁ = 1/(2^{x}.N.F_{PRP}), les autres cellules de retard (130) de la boucle à verrouillage de retard (124) appliquant un retard ΔT₂ > ΔT₁, ou
- chaque cellule de retard (130) applique un retard ΔT₃ = 1/(4.N.F_{PRP}).

7. Dispositif (100) selon l'une des revendications précédentes, dans lequel le circuit de commande (108) des générateurs (112.0 - 112.M) de signaux TORP comporte plusieurs portes ET (108.0 - 108.M) chacune configurée pour recevoir sur une première entrée un des bits du signal de code thermométrique et sur une deuxième entrée le signal périodique de fréquence F_{PRP}, les sorties des portes ET (108.0 - 108.M) sur lesquelles sont délivrés les signaux de commande d'alimentation étant couplées aux entrées de commande des circuits d'alimentation (116.0 - 116.M) des générateurs (112.0 - 112.M) de signaux TORP.

8. Dispositif (100) selon l'une des revendications précédentes, dans lequel le générateur (102) du signal de code thermométrique est configuré pour recevoir en entrée (104) un signal binaire de modulation d'amplitude codant sur P bits un de 2^{P} états d'amplitude différents, et pour convertir le signal binaire de modulation d'amplitude en signal de code thermométrique.

9. Dispositif (100) selon l'une des revendications précédentes, dans lequel le circuit de traitement (118) correspond à un additionneur.

10. Dispositif (100) selon l'une des revendications précédentes, dans lequel le circuit d'alimentation (116.0-116.M) de chacun des générateurs (112.0 - 112.M) de signaux TORP comporte au moins un interrupteur commandé.

11. Procédé de modulation d'amplitude avec 2^{P} états d'amplitude différents et P nombre entier supérieur ou égal à 1, mis en oeuvre avec un dispositif (100) de modulation d'amplitude comprenant plusieurs générateurs (112.0-112.M) de signaux TORP correspondant à des trains d'oscillations répétés périodiquement à une fréquence F_{PRP} dont les oscillations sont de fréquence F_{OL} égale à N.F_{PRP}, avec N nombre entier supérieur ou égal à 2, et dont chaque train d'oscillations a une durée inférieure à 1/F_{PRP}, chacun des générateurs (112.0-112.M) incluant au moins :
- un oscillateur (114.0-114.M) apte à générer un signal périodique de fréquence F_{OL}, et
- un circuit d'alimentation (116.0-116.M) configuré pour être commandé par un signal de commande d'alimentation périodique de fréquence F_{PRP} et relié à au moins une entrée d'alimentation électrique de l'oscillateur (114.0-114.M) tel qu'il génère, lorsque le générateur (112.0-112.M) de signal TORP est destiné à générer un train d'oscillations, une tension d'alimentation de l'oscillateur (114.0-114.M) non nulle seulement pendant une partie d'une période 1/F_{PRP},
dans lequel le procédé comprend au moins les étapes suivantes :
- génération d'un signal de code thermométrique codé sur au moins 2^{P} bits et codant un signal de modulation d'amplitude issu d'un signal d'information comprenant des symboles de données à coder,
- application ou non, en fonction de la valeur de chacun des bits du signal de code thermométrique, d'un signal périodique de fréquence F_{PRP} sur une entrée de commande du circuit d'alimentation (116.0-116.M) de chacun des générateurs (112.0 - 112.M) de signaux TORP, codant ainsi les symboles de données dans le signal de commande d'alimentation, et
- combinaison linéaire des signaux délivrés par les générateurs (112.0 - 112.M) de signaux TORP.

12. Procédé selon la revendication 11, dans lequel le procédé réalise une modulation de phase et d'amplitude et comporte en outre une génération d'un signal périodique de fréquence F_{PRP} modulé en phase, et dans lequel l'étape d'application du signal périodique de fréquence F_{PRP} est mise en oeuvre avec le signal périodique de fréquence F_{PRP} modulé en phase.

## Patentansprüche

1. Vorrichtung (100) zur Amplitudenmodulation mit 2^{P} unterschiedlichen Amplitudenzuständen und P Ganzzahl größer oder gleich 1, umfassend mindestens:
- mehrere Erzeuger (112.0-112.M) von TORP-Signalen, wobei jedes TORP-Signal periodisch in einer Frequenz F_{PRP} wiederholt Schwingungszügen entspricht, deren Schwingungen der Frequenz F_{OL} gleich N.F_{PRP} mit N Ganzzahl größer oder gleich 2 entsprechen und von denen jeder Schwingungszug eine Dauer von unter 1/F_{PRP} hat, wobei jeder der Erzeuger (112.0-112.M) eines TORP-Signals mindestens einschließt:
- einen Oszillator (114.0-114.M), der imstande ist, ein periodisches Frequenzsignal F_{OL} zu erzeugen, und
- einen Versorgungskreis (116.0-116.M), der ausgelegt ist, um von einem periodischen Versorgungs-Steuersignal mit der Frequenz F_{PRP} gesteuert zu werden und mit mindestens einem elektrischen Versorgungseingang des Oszillators (114.0-114.M) derart verbunden ist, dass er, wenn der TORP-Signalerzeuger (112.0-112.M) bestimmt ist, einen Schwingungszug zu erzeugen, eine Versorgungsspannung des Oszillators (114.0-114.M) von nicht null nur während eines Teils einer Periode 1/F_{LRL}, erzeugt,
- einen Erzeuger (102) eines thermometrischen Codesignals, das auf mindestens 2^{P} Bits codiert ist und ein aus einem Informationssignal hervorgegangenes Amplitudenmodulationssignal codiert, das codierende Datensymbole umfasst,
- einen Steuerkreis (108) der Erzeuger (112.0-112.M) von TORP-Signalen, der ausgelegt ist, um an einen Eingang der Steuerung des Versorgungskreises (116.0-116.M) jedes Erzeugers (112.0-112.M) von TORP-Signalen ein periodisches Frequenzsignal F_{PRP} in Abhängigkeit vom Wert von jedem der Bits des thermometrischen Codesignals anzulegen oder nicht, das somit die Datensymbole im Versorgungs-Steuersignal codiert, und
- einen Verarbeitungskreis (118), der Eingänge umfasst, die an Ausgänge der Erzeuger (112.0-112.M) von TORP-Signalen gekoppelt sind, und der ausgelegt ist, um eine lineare Kombination von Signalen durchzuführen, die über seine Eingänge bereitgestellt werden.

2. Vorrichtung (100) nach Anspruch 1, umfassend 2^{P} Erzeuger (112.0-112.M) von TORP-Signalen, und wobei das thermometrische Codesignal auf 2^{P} Bits codiert ist, so dass unabhängig vom Wert des Informationssignals eins der Bits des thermometrischen Codesignals einen Wert hat, der sich vom dem der anderen Bits des thermometrischen Codesignals unterscheidet.

3. Vorrichtung (100) nach einem der vorangehenden Ansprüche, wobei die Vorrichtung (100) ausgelegt ist, um eine Phasen- und Amplitudenmodulation durchzuführen und ferner mindestens einen Erzeuger (122) eines phasenmodulierten periodischen Frequenzsignals F_{PRP} aufweist und wobei der Steuerkreis (108) der Erzeuger (112.0-112.M) von TORP-Signalen ausgelegt ist, um an den Eingang der Steuerung des Versorgungskreises (116.0-116.M) von jedem der Erzeuger (112.0-112.M) von TORP-Signalen das phasenmodulierte periodische Frequenzsignal F_{PRP} in Abhängigkeit vom Wert von jedem der Bits des thermometrischen Codesignals anzulegen oder nicht.

4. Vorrichtung (100) nach Anspruch 3, wobei die Vorrichtung (100) ausgelegt ist, um eine Phasen- und Amplitudenmodulation mit 2^{X} unterschiedlichen Phasenzuständen durchzuführen und wobei der Erzeuger (122) des phasenmodulierten periodischen Frequenzsignals F_{PRP} ausgelegt ist, um auf das periodische Frequenzsignal F_{PRP} und für jedes zu codierende Symbol eine Verzögerung anzuwenden, die einem Vielfachen von 1/(2^{X}.F_{OL}) entspricht, wobei X eine Ganzzahl größer oder gleich 1 ist.

5. Vorrichtung (100) nach Anspruch 4, wobei der Erzeuger (122) des phasenmodulierten periodischen Frequenzsignals F_{PRP} mindestens aufweist:
- eine Verzögerungsverriegelungsschleife (124), die ausgelegt ist, um am Eingang das periodische Frequenzsignal F_{PRP} zu empfangen, und
- einen Multiplexer (138), der 2^{X} Eingänge (140) umfasst, die an verschiedene Verzögerungszellen (130) der Verzögerungsverriegelungsschleife (124) gekoppelt sind und über die 2^{X} voneinander unterschiedlich verzögerte periodische Frequenzsignale F_{PRP} erhalten werden, einen Steuerungseingang (142), über den ein Phasenmodulationssignal, das den für jedes Symbol anzuwendenden Phasenzustand bestimmt, bestimmt ist, angewendet zu werden, und einen Ausgang (144), über den das phasenmodulierte periodische Frequenzsignal F_{PRP} bestimmt ist, bereitgestellt zu werden, umfasst.

6. Vorrichtung (100) nach Anspruch 5, wobei:
- jedes Verzögerungszelle (130) eine Verzögerung ΔT₁ = 1/(2^{X}.N.F_{PRP}) anwendet, oder
- 2^{X} Verzögerungszellen (130) jeweils eine Verzögerung ΔT₁ = 1/(2^{X}.N.F_{PRP}) anwenden, wobei die anderen Verzögerungszellen (130) der Verzögerungsverriegelungsschleife (124) eine Verzögerung ΔT₂ > ΔT₁ anwenden, oder
- jede Verzögerungszelle (130) eine Verzögerung ΔT₃ = 1/(4.N.F_{PRP}) anwendet.

7. Vorrichtung (100) nach einem der vorangehenden Ansprüche, wobei der Steuerkreis (108) der Erzeuger (112.0-112.M) von TORP-Signalen mehrere ET-Ports (108.0-108.M) aufweist, die jeweils ausgelegt sind, um über einen ersten Eingang eins der Bits des thermometrischen Codesignals und über einen zweiten Eingang das periodische Frequenzsignal F_{PRP} zu empfangen, wobei die Ausgänge der ET-Ports (108.0-108.M), über die die Versorgungssteuersignale bereitgestellt werden, an die Steuereingänge der Versorgungskreise (116.0-116.M) der Erzeuger (112.0-112.M) von TORP-Signalen gekoppelt sind.

8. Vorrichtung (100) nach einem der vorangehenden Ansprüche, wobei der Erzeuger (102) des thermometrischen Codesignals ausgelegt ist, um am Eingang (104) ein binäres Signal Amplitudenmodulationssignal zu empfangen, das über P Bits einen von 2^{p} unterschiedlichen Amplitudenzuständen codiert und um das binäre Amplitudenmodulationssignal in thermometrisches Codesignal umzuwandeln.

9. Vorrichtung (100) nach einem der vorangehenden Ansprüche, wobei der Verarbeitungskreis (118) einem Addierer entspricht.

10. Vorrichtung (100) nach einem der vorangehenden Ansprüche, wobei der Versorgungskreis (116.0-116.M) jedes Erzeugers (112.0-112.M) von TORP-Signalen mindestens einen gesteuerten Schalter aufweist.

11. Verfahren zur Amplitudenmodulation mit 2^{P} unterschiedlichen Amplitudenzuständen und P Ganzzahl größer oder gleich 1, das mit einer Vorrichtung (100) zur Amplitudenmodulation durchgeführt wird, die mehrere Erzeuger (112.0-112.M) von TORP-Signalen umfasst, die Schwingungszügen entsprechen, die periodisch in einer Frequenz F_{PRP} wiederholt werden, deren Schwingungen der Frequenz F_{OL} gleich N.F_{PRP} sind mit N Ganzzahl größer oder gleich 2, und von denen jeder Schwingungszug eine Dauer von unter 1/F_{PRP} hat, wobei jeder der Erzeuger (112.0-112.M) mindestens einschließt:
- einen Oszillator (114.0-114.M), der imstande ist, ein periodisches Frequenzsignal F_{OL} zu erzeugen, und
- einen Versorgungskreis (116.0-116.M), der ausgelegt ist, um von einem periodischen Versorgungs-Steuersignal mit der Frequenz F_{PRP} gesteuert zu werden und mit mindestens einem elektrischen Versorgungseingang des Oszillators (114.0-114.M) derart verbunden ist, dass er, wenn der TORP-Signalerzeuger (112.0-112.M) bestimmt ist, einen Schwingungszug zu erzeugen, eine Versorgungsspannung des Oszillators (114.0-114.M) von nicht null nur während eines Teils einer Periode 1/F_{LRL}, erzeugt,
wobei das Verfahren mindestens die folgenden Schritte umfasst:
- Erzeugen eines thermometrischen Codesignals, das auf mindestens 2^{P} Bits codiert ist und ein aus einem Informationssignal hervorgegangenes Amplitudenmodulationssignal codiert, das zu codierende Datensymbole umfasst,
- Anwenden oder nicht, in Abhängigkeit vom Wert von jedem der Bits des thermometrischen Codesignals, eines periodischen Frequenzsignals F_{PRP} auf einen Eingang der Steuerung des Versorgungskreises (116.0-116.M) jedes Erzeugers (112.0-112.M) von TORP-Signalen, das somit die Datensymbole im Versorgungs-Steuersignal codiert, und
- lineare Kombination der von den Erzeugern (112.0-112.M) von TORP-Signalen bereitgestellten Signale.

12. Verfahren nach Anspruch 11, wobei das Verfahren eine Phasen- und Amplitudenmodulation durchführt und ferner eine Erzeugung eines phasenmodulierten periodischen Frequenzsignals F_{PRP} aufweist und wobei der Schritt der Anwendung des periodischen Frequenzsignals F_{PRP} mit dem phasenmodulierten periodischen Frequenzsignal F_{PRP} durchgeführt wird.

## Claims

1. An amplitude modulation device (100) with 2^{P} different amplitude states and P integer greater than or equal to 1, comprising at least:
- several TORP signal generators (112.0-112.M), each TORP signal corresponding to oscillation trains periodically repeated at a frequency F_{PRP} whose oscillations are of frequency F_{OL} equal to N.F_{PRP}, with N integer greater than or equal to 2, and each oscillation train of which has a duration of less than 1/F_{PRP}, each of the TORP signal generators (112.0-112.M) including at least:
- an oscillator (114.0-114.M) capable of generating a periodic signal of frequency F_{OL}, and
- a power supply circuit (116.0-116.M) configured to be controlled by a periodic power supply control signal of frequency F_{PRP} and connected to at least one power supply input of the oscillator (114.0-114.M) as it generates, when the TORP signal generator (112.0-112.M) is intended to generate an oscillation train, a power supply voltage of the oscillator (114.0-114.M) which is non-zero only during part of a period 1/F_{PRP},
- a generator (102) of a thermometric code signal coded on at least 2^{P} bits and coding an amplitude modulation signal from an information signal comprising data symbols to be coded,
- a control circuit (108) for the TORP signal generators (112.0-112.M), configured to apply or not, to a control input of the power supply circuit (116.0-116.M) of each of the TORP signal generators (112.0-112.M), a periodic signal of frequency F_{PRP} according to the value of each of the bits of the thermometric code signal, thus coding the data symbols in the power supply control signal, and
- a processing circuit (118) comprising inputs coupled to outputs of TORP signal generators (112.0 - 112.M), and configured to produce a linear combination of signals applied on its inputs.

2. Device (100) according to claim 1, comprising 2^{P} TORP signal generators (112.0-112.M), and wherein the thermometric code signal is coded on 2^{P} bits such that, regardless of the value of the information signal, one of the bits of the thermometric code signal has a value different from that of the other bits of the thermometric code signal.

3. Device (100) according to one of previous claims, wherein the device (100) is configured to perform a phase and amplitude modulation and further includes at least one generator (122) of a phase-modulated periodic signal of frequency F_{PRP}, and wherein the control circuit (108) for the TORP signal generators (112.0 - 112.M) is configured to apply or not, to the control input of the power supply circuit (116.0 - 116.M) of each of the TORP signal generators (112.0 - 112.M), the phase-modulated periodic signal of frequency F_{PRP} depending on the value of each of the bits of the thermometric code signal.

4. Device (100) according to claim 3, wherein the device (100) is configured to perform a phase and amplitude modulation with 2^{X} different phase states, and wherein the generator (122) of the phase-modulated periodic signal of frequency F_{PRP} is configured to apply, to the periodic signal of frequency F_{PRP}, and for each symbol to be coded, a delay corresponding to a multiple of 1/(2^{x}.F_{OL}), X being an integer greater than or equal to 1.

5. Device (100) according to claim 4, wherein the generator (122) of the phase-modulated periodic signal of frequency F_{PRP} includes at least:
- a delay locked loop (124) configured to receive as input the periodic signal of frequency F_{PRP}, and
- a multiplexer (138) comprising 2^{X} inputs (140) coupled to different delay cells (130) of the delay locked loop (124) and on which 2^{X} periodic signals of frequency F_{PRP} delayed differently from each other are obtained, a control input (142) on which a phase modulation signal determining the phase state to be applied for each symbol is intended to be applied, and an output (144) on which the phase-modulated periodic signal of frequency F_{PRP} is intended to be outputted.

6. Device (100) according to claim 5, wherein:
- each delay cell (130) applies a delay ΔT₁ = 1/(2^{x}.N.F_{PRP}), or
- 2^{X} delay cells (130) each apply a delay ΔT₁ = 1/(2^{x}.N.F_{PRP}), the other delay cells (130) of the delay locked loop (124) applying a delay ΔT₂ > ΔT₁, or
- each delay cell (130) applies a delay ΔT₃ = 1/(4.N.F_{PRP}).

7. Device (100) according to one of previous claims, wherein the control circuit (108) for the TORP signal generators (112.0 - 112.M) includes several AND gates (108.0 - 108.M) each configured to receive on a first input one of the bits of the thermometric code signal and on a second input the periodic signal of frequency F_{PRP}, the outputs of the AND gates (108.0- 108.M) on which are outputted the power supply control signals being coupled to the control inputs of the power supply circuits (116.0 - 116.M) of the TORP signal generators (112.0 - 112.M).

8. Device (100) according to one of previous claims, wherein the generator (102) of the thermometric code signal is configured to receive as input (104) a binary amplitude modulation signal coding on P bits one of 2^{p} different amplitude states, and to convert the binary amplitude modulation signal into a thermometric code signal.

9. Device (100) according to one of previous claims, wherein the processing circuit (118) corresponds to an adder.

10. Device (100) according to one of previous claims, wherein the power supply circuit (116.0-116.M) of each of the TORP signal generators (112.0 - 112.M) includes at least one controlled switch.

11. An amplitude modulation method with 2^{P} different amplitude states and P integer greater than or equal to 1, implemented with an amplitude modulation device (100) comprising several TORP signal generators (112.0-112.M) which correspond to oscillation trains periodically repeated at a frequency F_{PRP} whose oscillations are of frequency F_{OL} equal to N.F_{PRP}, with N integer greaterthan or equal to 2, and each oscillation train of which has a duration of less than 1/F_{PRP}, each of the generators (112.0-112.M) including at least:
- an oscillator (114.0-114.M) capable of generating a periodic signal of frequency F_{OL}, and
- a power supply circuit (116.0-116.M) configured to be controlled by a periodic power supply control signal of frequency F_{PRP} and connected to at least one power supply input of the oscillator (114.0-114.M) such that it generates, when the TORP signal generator (112.0-112.M) is intended to generate an oscillation train, a power supply voltage of the oscillator (114.0-114.M) which is non-zero only during part of each period 1/F_{PRP},
wherein the method comprises at least the following steps:
- generation of a thermometric code signal coded on at least 2^{P} bits and coding an amplitude modulation signal from an information signal comprising data symbols to be coded,
- application or not, depending on the value of each of the bits of the thermometric code signal, of the periodic signal of frequency F_{PRP} to a control input of the power supply circuit (116.1-116.M) of each TORP signal generator (112.0 - 112.M), thus coding the data symbols in the power supply control signal, and
- linear combination of the signals outputted by the TORP signal generators (112.0 - 112.M).

12. Method according to claim 11, wherein the method performs an amplitude and phase modulation and further comprises a generation of a phase-modulated periodic signal of frequency F_{PRP}, and wherein the application step of the periodic signal of frequency F_{PRP} is implemented with the phase-modulated periodic signal of frequency F_{PRP}.
